# EUROPEAN PATENT APPLICATION

(11) **EP 4 435 832 A1**
(43) Date of publication of application: **25.09.2024**
(21) Application number: 21827379.5
(22) Date of filing: 30.11.2021

(54) **ORGANIC LIGHT-EMITTING DIODE DISPLAY PANEL AND MANUFACTURING METHOD THEREFOR**

(30) Priority: 15.11.2021 CN 202111347742
(71) Applicant: TCL China Star Optoelectronics Tehnology Co., Ltd., Shenzhen, Guangdong 518132 (CN)
(72) Inventor: REN, Xuechao, Shenzhen, Guangdong 518132 (CN)
(74) Representative: Petraz, Gilberto Luigi
(86) International application number: PCT/CN2021/134368
(87) International publication number: WO 2023/082370

(57) **Abstract**

An organic light-emitting diode display panel includes a thin-film transistor substrate, a plurality of thin-film transistors, and a plurality of organic light-emitting diodes. The thin-film transistors are disposed on a side of the thin-film transistor substrate. The organic light-emitting diodes are disposed on a side of the thin-film transistor substrate away from the thin-film transistors. The organic light-emitting diodes are disposed on a flat surface and will not be affected by surface fluctuations caused by the thin-film transistors. A space usage of the organic light-emitting diodes can be maximized, thereby increasing a pixel density of the organic light-emitting diode display panel.

## Description

### FIELD OF INVENTION

The present invention is related to the field of display technology and specifically to an organic light-emitting diode display panel and a manufacturing method thereof.

### BACKGROUND OF INVENTION

Organic light-emitting diode display panels have advantages of wide viewing angles and wide color gamut. As mainstream display panels, they have been paid attention and developed by major display device manufacturers. Currently, the organic light-emitting diode display panels mostly use thin-film transistors with top gate structures, which are top-gate thin-film transistors. Compared with traditional thin-film transistors with bottom-gate structures, the top-gate thin-film transistors reduce manufacturing processes of the organic light-emitting diode display panels, thereby reducing manufacturing costs.

However, in a top-gate thin-film transistor, a gate positioned in the middle of the top-gate thin-film transistor often causes a surface of the top-gate thin-film transistor to fluctuate, making a surface flatness of the top-gate thin-film transistor poor. When the surface of the top-gate thin-film transistor is not flat enough, it will affect a light-emitting effect of a light-emitting layer on the top-gate thin-film transistor.

In the prior art, in order to increase the surface flatness of the top-gate thin-film transistor, a leveling layer is usually added onto the top-gate thin-film transistor. The leveling layer enables the light-emitting layer to be disposed on a flat surface of the leveling layer to increase the light-emitting effect of the light-emitting layer.

Although the above-mentioned structure of the prior art can increase a display effect of the organic light-emitting diode display panel using the top-gate thin-film transistor, it also increases a thickness of the organic light-emitting diode display panel, increases manufacturing processes and manufacturing costs of the organic light-emitting diode display panel, and even affects flexibility of the organic light-emitting diode display panel.

Therefore, the traditional technology cannot take into account original advantages of the organic light-emitting diode display panel and solve technical problems of the top-gate thin-film transistor.

### SUMMARY OF INVENTION

The present invention provides an organic light-emitting diode display panel and a manufacturing method thereof, which can prevent problems faced by a traditional organic light-emitting diode display panel when using top-gate thin-film transistors. Meanwhile, the present invention can simplify manufacturing processes of the organic light-emitting diode display panel, enhance a light-emitting effect of the organic light-emitting diode display panel, and increase a pixel density of the organic light-emitting diode display panel, so as to enable viewers to obtain a better viewing effect.

The organic light-emitting diode display panel of the present invention includes a thin-film transistor substrate, a plurality of thin-film transistors, and a plurality of organic light-emitting diodes. The thin-film transistors are disposed on a side of the thin-film transistor substrate. The organic light-emitting diodes are disposed on a side of the thin-film transistor substrate away from the thin-film transistors.

In an embodiment, each of the thin-film transistors includes a gate, a source, a drain, and a semiconductor layer. The semiconductor layer is electrically connected to the source and the drain. Each of the organic light-emitting diodes corresponds to each of the thin-film transistors and includes a first electrode, a light-emitting layer, and a second electrode. The first electrode is electrically connected to the source or the drain. The first electrode is disposed on the side of the thin-film transistor substrate away from the thin-film transistors. The light-emitting layer is disposed on a side of the first electrode away from the thin-film transistor substrate. The second electrode is disposed on a side of the light-emitting layer away from the first electrode.

In an embodiment, an area of the first electrode is greater than or equal to an area of the semiconductor layer. The first electrode blocks light from irradiating the semiconductor layer.

In an embodiment, a material of the first electrode includes an opaque material.

In an embodiment, the source and the drain are disposed on a side of the semiconductor layer away from the thin-film transistor substrate, and the gate is disposed on a side of the source and the drain away from the semiconductor layer.

In an embodiment, the gate is disposed on a side of the semiconductor layer away from the thin-film transistor substrate, and the source and the drain are disposed on a side of the gate away from the semiconductor layer.

In an embodiment, a total projected area of the gate, the source, and the drain on the semiconductor layer is greater than or equal to an area of the semiconductor layer. The gate, the source, and the drain block light from irradiating the semiconductor layer.

In an embodiment, the thin-film transistor substrate includes a through-hole, and the first electrode is electrically connected to the thin-film transistor through the through-hole.

In an embodiment, the organic light-emitting diode display panel further includes a peeling layer disposed between the thin-film transistor substrate and the organic light-emitting diodes.

In an embodiment, a material of the peeling layer includes gallium nitride.

The manufacturing method of the organic light-emitting diode display panel of the present invention includes steps of:
S 1, forming a peeling layer;
S2, forming a thin-film transistor substrate on a side of the peeling layer;
S3, forming a plurality of thin-film transistors on a side of the thin-film transistor substrate away from the peeling layer; and
S4, forming a plurality of organic light-emitting diodes on a side of the peeling layer away from the thin-film transistor substrate.

In an embodiment, step S3 includes steps of:
S31, forming a semiconductor layer on the side of the thin-film transistor substrate away from the peeling layer;
S32, forming a gate insulating layer on a side of the semiconductor layer away from the thin-film transistor substrate;
S33, forming a gate on a side of the gate insulating layer away from the semiconductor layer;
S34, forming an interlayer dielectric layer on the side of the thin-film transistor substrate away from the peeling layer;
S35, defining a through-hole passing through the interlayer dielectric layer, the thin-film transistor substrate, and the peeling layer; and
S36, forming a source and a drain on a side of the interlayer dielectric layer away from the thin-film transistor substrate.

In an embodiment, a total projected area of the gate, the source, and the drain on the semiconductor layer is greater than or equal to an area of the semiconductor layer. The gate, the source, and the drain block light from irradiating the semiconductor layer.

In an embodiment, step S36 includes steps of:
S361, filling the through-hole with a conductive material;
S362, electrically connecting the source and the conductive material in the through-hole; or
S362', electrically connecting the drain and the conductive material in the through-hole.

In an embodiment, step S4 includes a step of forming a first electrode on a side of the thin-film transistor substrate away from the thin-film transistors, forming a light-emitting layer on a side of the first electrode away from the thin-film transistor substrate, and forming a second electrode on a side of the light-emitting layer away from the first electrode.

In an embodiment, an area of the first electrode is greater than or equal to an area of the semiconductor layer. The first electrode blocks light from irradiating the semiconductor layer.

In an embodiment, a material of the first electrode includes an opaque material.

In an embodiment, step S1 includes a step of forming a peeling layer on a side of the first substrate. Before step S4, the manufacturing method further includes a step of separating the first substrate from the peeling layer.

In an embodiment, the peeling layer is separated from the first substrate by a laser ablation process.

In an embodiment, a material of the peeling layer includes gallium nitride.

In the organic light-emitting diode display panel and the manufacturing method of the organic light-emitting diode display panel of the present invention, a traditional leveling layer and the organic light-emitting diodes are not disposed on the thin-film transistors. On the contrary, the organic light-emitting diodes are disposed on the side of the thin-film transistor substrate away from the thin-film transistors. Therefore, in the organic light-emitting diode display panel of the present invention, the organic light-emitting diodes are disposed on a flat surface and will not be affected by surface fluctuations caused by the gates of the thin-film transistors. Since the organic light-emitting diodes can be disposed on the flat surface, a space usage of the light-emitting layer can be maximized, thereby increasing a pixel density of the organic light-emitting diode display panel. Meanwhile, the gate, the source, the drain, and the first electrode disposed on an upper side and a lower side of each of the thin-film transistors can also function as a light-shielding layer that blocks light for the semiconductor layer in each of the thin-film transistors. This can simplify manufacturing processes of the organic light-emitting diode display panel, increase a display efficiency of the thin-film transistors, and enhance a light-emitting effect of the organic light-emitting diode display panel, so as to enable viewers to obtain a better viewing effect.

### DESCRIPTION OF DRAWINGS

FIG. 1 is a structural schematic diagram of an organic light-emitting diode display panel of the present invention.
FIG. 2 is a flowchart of steps S1-S4 of a manufacturing method of the organic light-emitting diode display panel of the present invention.
FIG. 3 is a flowchart of steps S31-S36 of the manufacturing method of the organic light-emitting diode display panel of the present invention.
FIG. 4 is a flowchart of steps S361-S362/S362' of the manufacturing method of the organic light-emitting diode display panel of the present invention.
FIGs. 5-19 are structural schematic diagrams showing the organic light-emitting diode display panel of the present invention at different manufacturing processes.

### DETAILED DESCRIPTION OF EMBODIMENTS

In order to make the above purposes, features, and advantages of the present invention more obvious and understandable, the following is a detailed description of preferred embodiments of the present invention in conjunction with accompanying drawings.

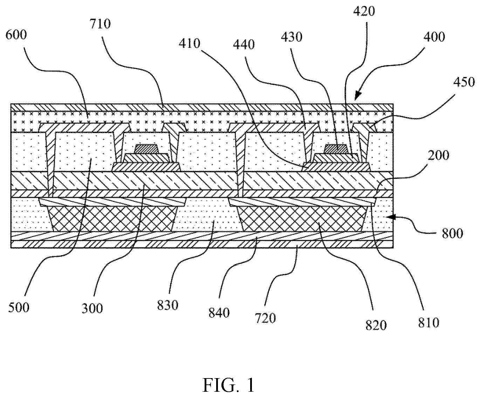

The invention provides an organic light-emitting diode display panel. Please refer to FIG. 1, which is a structural schematic diagram of the organic light-emitting diode display panel of the present invention. The organic light-emitting diode display panel includes a peeling layer 200, a thin-film transistor substrate 300, a plurality of thin-film transistors 400, and a plurality of organic light-emitting diodes 800.

The peeling layer is made of semiconductor materials, including organic semiconductors or inorganic semiconductors. In an embodiment, a material of the peeling layer 200 of the present invention includes gallium nitride (GaN) of an inorganic semiconductor. When the peeling layer 200 made of gallium nitride is irradiated by a laser, it will generate gas, which can separate components connected on its surface. Applications of the peeling layer 200 to a manufacturing method of the organic light-emitting diode display panel of the present invention will be described in subsequent embodiments.

As shown in FIG. 1, the thin-film transistor substrate 300 is disposed on a side of the peeling layer 200, and the thin-film transistors 400 are disposed on a side of the thin-film transistor substrate 300 away from the peeling layer 200. Since the thin-film transistor substrate 300 insulates the peeling layer 200 from the thin-film transistors 400, it can be ensured that the peeling layer 200 will not directly contact the thin-film transistors 400, thereby preventing operations of the thin-film transistors 400 from affecting.

Each of the thin-film transistors 400 serves as a driving switch for each of the organic light-emitting diodes 800, and includes a semiconductor layer 410, a gate insulating layer 420, a gate 430, a source 440, and a drain 450. In an embodiment, the source 440 and the drain 450 are disposed on a side of the gate 430 away from the thin-film transistor substrate 300. By controlling an input voltage of the gate 430, each of the thin-film transistors 400 can control the on and off of a current at both ends of the source 440 and the drain 450.

The present invention is described by taking a top-gate thin-film transistor as an example for each of the thin-film transistors 400. The top-gate thin-film transistor reduces manufacturing processes of the organic light-emitting diode display panel, thereby reducing manufacturing costs. However, each of the thin-film transistors 400 of the present invention is not limited to the top-gate thin-film transistor, and may also be a bottom-gate thin-film transistor or a thin-film transistor having other structures.

As shown in FIG. 1, the gate 430 is disposed on a side of the semiconductor layer 410 away from the thin-film transistor substrate 300. The source 440 and the drain 450 are disposed on a side of the gate 430 away from the semiconductor layer 410. The semiconductor layer 410 is disposed between the thin-film transistor substrate 300 and the gate 430. The gate insulating layer 420 is disposed between the semiconductor layer 410 and the gate 430. The source 440 and the drain 450 are electrically connected to the semiconductor layer 410.

The semiconductor layer 410 includes a metal oxide with a wide energy gap, so the semiconductor layer 410 of the present invention can construct a connection channel for the source 440 and the drain 450. In an embodiment, the semiconductor layer 410 of the present invention includes indium gallium zinc oxide (IGZO). An electron mobility of the indium gallium zinc oxide is 20-30 times that of a traditional amorphous silicon semiconductor, so a charge and discharge rate and response speed of each of the thin-film transistors 400 are significantly increased. Using the indium gallium zinc oxide as the channel of each of the thin-film transistors 400 can achieve a faster refresh rate of the organic light-emitting diode display panel. Meanwhile, the indium gallium zinc oxide has a better driving capability, so driving power consumption of each of the thin-film transistors 400 is low, which makes the organic light-emitting diode display panel more energy-saving and power-saving, thereby greatly increasing a battery life of the organic light-emitting diode display panel.

As shown in FIG. 1, the organic light-emitting diode display panel further includes an interlayer dielectric layer 500. The interlayer dielectric layer 500 covers the semiconductor layer 410, the gate insulating layer 420, and the gate 430. The interlayer dielectric layer 500 has a high dielectric constant, which is used to insulate the gate 430 from the source 440 and the drain 450.

As shown in FIG. 1, the organic light-emitting diode display panel further includes a passivation layer 600 and a first encapsulation layer 710 sequentially disposed on a side of the thin-film transistors 400 away from the thin-film transistor substrate 300. The passivation layer 600 covers the source 440 and the drain 450 of each of the thin-film transistors 400, and further covers the interlayer dielectric layer 500. The passivation layer 600 not only has an insulating effect, but also imparts toughness to the organic light-emitting diode display panel when flexed. Through the arrangement of the first encapsulation layer 710, an outer side of the organic light-emitting diode display panel can be encapsulated to protect the organic light-emitting diode display panel.

As shown in FIG. 1, the organic light-emitting diodes 800 are disposed on a side of the thin-film transistor substrate 300 away from the thin-film transistors 400. Each of the organic light-emitting diodes 800 corresponds to each of the thin-film transistors 400. Each of the organic light-emitting diodes 800 includes a first electrode 810, a light-emitting layer 820, and a second electrode 840.

In an embodiment, the first electrode 810 is disposed on a side of the peeling layer 200 away from the thin-film transistor substrate 300. The first electrode 810 corresponds to each of the thin-film transistors 400. When the first electrode 810 is disposed on a flat surface of the peeling layer 200, the light-emitting layer 820 can achieve the best space utilization efficiency and increase a pixel density of the organic light-emitting diode display panel.

In an embodiment, the source 440 of each of the thin-film transistors 400 is electrically connected to the first electrode 810. In another embodiment, the drain 450 of each of the thin-film transistors 400 is electrically connected to the first electrode 810. Since the work performed by the source 440 or the drain 450 in each of the thin-film transistors 400 is only inputting or outputting a current, the present invention does not limit the source 440 or the drain 450 to be electrically connected to the first electrode 810.

As shown in FIG. 1, the light-emitting layer 820 is disposed on a side of the first electrode 810 away from the peeling layer 200. In the present invention, the light-emitting layer 820 is disposed on a surface of the first electrode 810 through an inkjet printing process. Meanwhile, a pixel spacer 830 is filled between the light-emitting layers 820, so that the light-emitting layer 820 forms pixels of the organic light-emitting diode display panel.

The second electrode 840 is disposed on a side of the light-emitting layer 820 away from the first electrode 810. The second electrode 840 covers the light-emitting layer 820 and the pixel spacer 830, and works as a common electrode with the first electrode 810 to drive the light-emitting layer 820 to emit light.

In addition, it should be noted that the semiconductor layer 410 of each of the thin-film transistors 400 is sensitive to light. When light is irradiated on the semiconductor layer 410, a drift current effect is likely to occur and affect a driving effect of each of the thin-film transistors 400. Therefore, the traditional technology usually requires additional light-shielding layers to be provided on an upper side and a lower side of the semiconductor layer 410 of each of the thin-film transistors 400.

However, in the present invention, the gate 430, the source 440, the drain 450, and the first electrode 810 can also provide a light shielding effect for the semiconductor layer 410, which can block light from irradiating the semiconductor layer 410. Meanwhile, since the gate 430, the source 440, and the drain 450 are disposed on a side of the semiconductor layer 410, and the first electrode 810 is disposed on a side of the semiconductor layer 410 away from the gate 430, the source 440, and the drain 450, the gate 430, the source 440, the drain 450, and the first electrode 810 can achieve the light-shielding effect of the light-shielding layer in the prior art, so the present invention can also simplify a structure of the organic light-emitting diode display panel.

In order to achieve the above-mentioned purpose, in an embodiment of the present invention, a total projected area of the gate 430, the source 440, and the drain 450 on the semiconductor layer 410 is greater than or equal to an area of the semiconductor layer 410. In addition, an area of the first electrode 810 is configured to be greater than or equal to an area of the semiconductor layer 410 of each of the thin-film transistors 400. Also, a material of the first electrode 810 is an opaque conductive material, such as silver (Ag), indium tin oxide/silver/indium tin oxide (ITO/Ag/ITO) composite layer, indium zinc oxide/silver/ indium zinc oxide (IZO/Ag/IZO) composite layer, indium tin oxide/silver palladium copper alloy/indium tin oxide (ITO/APC/ITO) composite layer, or indium zinc oxide/silver palladium copper alloy/indium zinc oxide (IZO/APC/IZO) composite layer.

As shown in FIG. 1, the organic light-emitting diode display panel of the present invention further includes a second encapsulation layer 720 disposed on a surface of the second electrode 840. Through the arrangement of the second encapsulation layer 720, a bottom side of the organic light-emitting diode display panel can be encapsulated to protect the organic light-emitting diode display panel.

In the organic light-emitting diode display panel of the present invention, the traditional leveling layer and the organic light-emitting diodes 800 are not disposed on the thin-film transistors 400. On the contrary, the organic light-emitting diodes 800 are disposed on the side of the thin-film transistor substrate 300 away from the thin-film transistors 400. Therefore, in the organic light-emitting diode display panel of the present invention, the organic light-emitting diodes 800 are disposed on a flat surface and will not be affected by surface fluctuations caused by the gates 430 of the thin-film transistors 400. Since the organic light-emitting diodes 800 can be disposed on the flat surface, a space usage of the light-emitting layer 820 can be maximized, thereby increasing the pixel density of the organic light-emitting diode display panel. Meanwhile, the gate 430, the source 440, the drain 450, and the first electrode 810 disposed on an upper side and a lower side of each of the thin-film transistors 400 can also function as the light-shielding layer that blocks light for the semiconductor layer 410 in each of the thin-film transistors 400. This can simplify the manufacturing processes of the organic light-emitting diode display panel, increase a display efficiency of the thin-film transistors, and enhance a light-emitting effect of the organic light-emitting diode display panel, so as to enable viewers to obtain a better viewing effect.

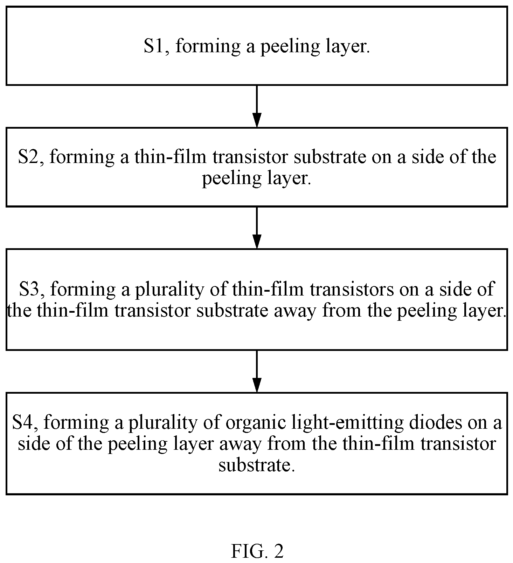

The present invention further provides a manufacturing method of the above-mentioned organic light-emitting diode display panel. Please refer to FIG. 2, which is a flowchart of steps S1-S4 of the manufacturing method of the organic light-emitting diode display panel of the present invention. The manufacturing method of the organic light-emitting diode display panel of the present invention shown in FIG. 1 mainly includes the following steps S1-S4.
S1, forming a peeling layer 200.
S2, forming a thin-film transistor substrate 300 on a side of the peeling layer 200.
S3, forming a plurality of thin-film transistors 400 on a side of the thin-film transistor substrate 300 away from the peeling layer 200.
S4, forming a plurality of organic light-emitting diodes 800 on a side of the peeling layer 200 away from the thin-film transistor substrate 300.

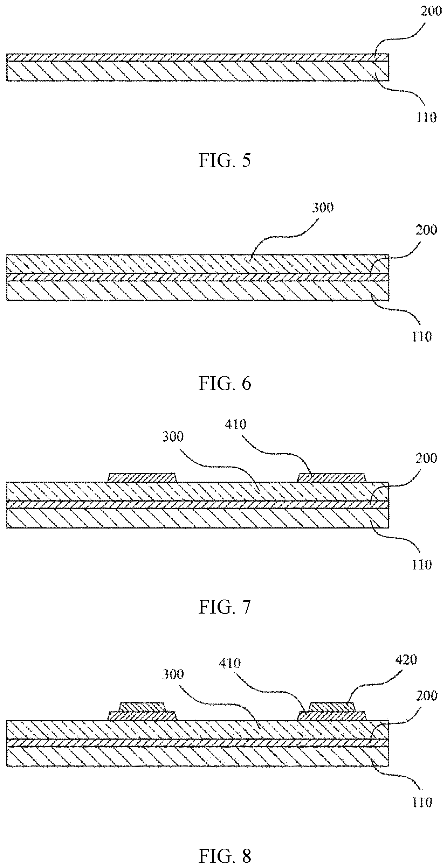

Technical solutions of the present invention will be described below in conjunction with structural schematic diagrams of the manufacturing process of the organic light-emitting diode display panel shown in FIGs. 5-19.

Please refer to FIG. 5, in step S1 of FIG. 2, the peeling layer 200 is formed. The peeling layer is made of semiconductor materials, including organic semiconductors or inorganic semiconductors. In an embodiment, a material of the peeling layer 200 of the present invention includes gallium nitride (GaN) of an inorganic semiconductor.

In an embodiment, step S1 includes forming the peeling layer 200 on a side of the first substrate 110. As shown in FIG. 5, the first substrate 110 may be a glass substrate usually used in display panel industry, which provides a simple and convenient initial process for the manufacturing method of the organic light-emitting diode display panel of the present invention.

Please refer to FIG. 6, in step S2 of FIG. 2, a thin-film transistor substrate 300 is formed on a side of the peeling layer 200 away from the first substrate 110. As shown in FIG. 1, since the thin-film transistor substrate 300 insulates the peeling layer 200 from the thin-film transistors 400, it can be ensured that the peeling layer 200 will not directly contact the thin-film transistors 400 formed in subsequent step S3, thereby preventing operations of the thin-film transistors 400 from affecting.

In step S3 of FIG. 2, the thin-film transistors 400 shown in FIG. 1 are formed on the side of the thin-film transistor substrate 300 away from the peeling layer 200.

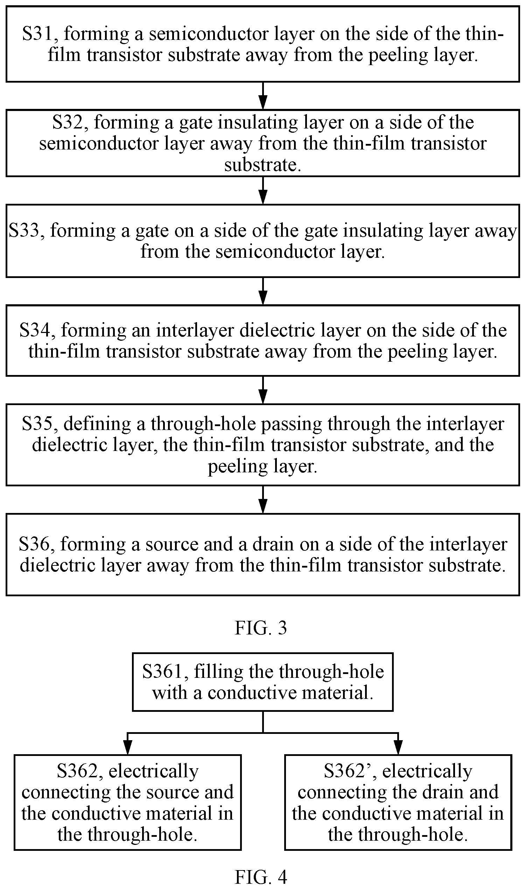

Please refer to FIG. 3, which is a flowchart of steps S31-S36 of the manufacturing method of the organic light-emitting diode display panel of the present invention. In an embodiment, step S3 includes the following steps S31-S36 to form each of the thin-film transistors 400 shown in FIG. 1.
S31, forming a semiconductor layer 410 on the side of the thin-film transistor substrate 300 away from the peeling layer 200.
S32, forming a gate insulating layer 420 on a side of the semiconductor layer 410 away from the thin-film transistor substrate 300.
S33, forming a gate 430 on a side of the gate insulating layer 420 away from the semiconductor layer 410.
S34, forming an interlayer dielectric layer 500 on the side of the thin-film transistor substrate 300 away from the peeling layer 200.
S35, defining a through-hole 510 passing through the interlayer dielectric layer 500, the thin-film transistor substrate 300, and the peeling layer 200.
S36, forming a source 440 and a drain 450 on a side of the interlayer dielectric layer 500 away from the thin-film transistor substrate 300.

Please refer to FIG. 7, in step S31, the semiconductor layer 410 is formed on the side of the thin-film transistor substrate 300 away from the peeling layer 200 through a photolithography process. The semiconductor layer 410 includes a metal oxide with a wide energy gap, so the semiconductor layer 410 of the present invention can construct a connection channel for the source 440 and the drain 450 shown in FIG. 1 formed in step S36. In an embodiment, the semiconductor layer 410 of the present invention includes indium gallium zinc oxide (IGZO). An electron mobility of the indium gallium zinc oxide is 20-30 times that of a traditional amorphous silicon semiconductor, so a charge and discharge rate and response speed of each of the thin-film transistors 400 shown in FIG. 1 are significantly increased. Using the indium gallium zinc oxide as the channel of each of the thin-film transistors 400 can achieve a faster refresh rate of the organic light-emitting diode display panel. Meanwhile, the indium gallium zinc oxide has a better driving capability, so driving power consumption of each of the thin-film transistors 400 is low, which makes the organic light-emitting diode display panel more energy-saving and power-saving, thereby greatly increasing a battery life of the organic light-emitting diode display panel.

Please refer to FIG. 8, in step S32, the gate insulating layer 420 is formed on the side of the semiconductor layer 410 away from the thin-film transistor substrate 300 through the photolithography process. As shown in FIG. 1, the gate insulating layer 420 is configured to insulate the semiconductor layer 410 from the gate 430 formed in subsequent step S33. In an embodiment, the gate insulating layer 420 is disposed on the semiconductor layer 410, and edges of the gate insulating layer 420 are retracted compared to edges of the semiconductor layer 410, which means that a lower surface area of the gate insulating layer 420 is smaller than an upper surface area of the semiconductor layer 410. The purpose is to reserve positions of the left and right sides of the semiconductor layer 410 to facilitate connections between the source 440 and the drain 450 formed in subsequent step S36.

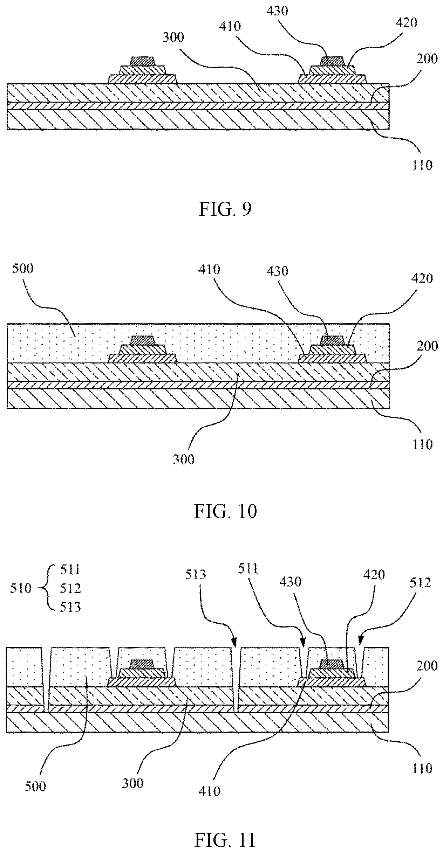

Please refer to FIG. 9, in step S33, the gate 430 is formed on the side of the gate insulating layer 420 away from the semiconductor layer 410 through the photolithography process. In an embodiment, the gate 430 is disposed on the gate insulating layer 420, and edges of the gate 430 is retracted compared to the edges of the gate insulating layer 420, which means that a lower surface area of the gate 430 is smaller than an upper surface area of the gate insulating layer 420. The purpose is to prevent the gate 430 from going beyond the edges of the gate insulating layer 420, and to retain positions of the left and right sides of the semiconductor layer 410 to facilitate connections between the source 440 and the drain 450 shown in FIG. 1 formed in subsequent step S36.

Please refer to FIG. 10, in step S34, the interlayer dielectric layer 500 is formed on the side of the thin-film transistor substrate 300 away from the peeling layer 200 through a coating process. After the interlayer dielectric layer 500 is coated on the thin-film transistor substrate 300, it will cover the semiconductor layer 410, the gate insulating layer 420, and the gate 430. The interlayer dielectric layer 500 has a high dielectric constant, which is configured to insulate the gate 430 from the source 440 and the drain 450 shown in FIG. 1 formed in subsequent step S36.

Please refer to FIG. 11, in step S35, the interlayer dielectric layer 500, the thin-film transistor substrate 300, and the peeling layer 200 are etched at different depths through a halftone mask, so as to form the through-holes 510 passing through the interlayer dielectric layer 500, the thin-film transistor substrate 300, and the peeling layer 200. Since the semiconductor layer 410, the gate insulating layer 420, and the gate 430 are covered by the interlayer dielectric layer 500, the source 440 and the drain 450 shown in FIG. 1 formed in subsequent step S36 cannot be electrically connected to the semiconductor layer 410. Therefore, when forming each of the thin-film transistors 400, it is necessary to form an electrical connection channel through an etching process. The through-holes 510 include a source through-hole 511 and a drain through-hole 512. The source through-hole 511 and the drain through-hole 512 pass through the interlayer dielectric layer 500 and expose the semiconductor layer 410. In an embodiment, the through-holes 510 further include a first electrode through-hole 513. The first electrode through-hole 513 passes through the interlayer dielectric layer 500, the thin-film transistor substrate 300, and the peeling layer 200, and exposes the first substrate 110.

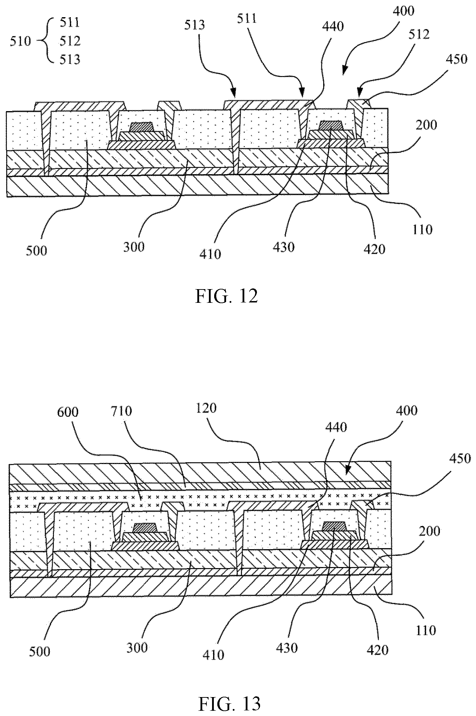

Please refer to FIG. 12, in step S36, the source 440 and the drain 450 are formed on the side of the interlayer dielectric layer 500 away from the thin-film transistor substrate 300 through the photolithography process. The thin-film transistors 400 formed in step S3 of the present invention are top-gate thin-film transistors.

As shown in FIG. 12, in the present invention, each of the thin-film transistors 400 serves as a driving switch for each of the organic light-emitting diodes 800, and includes the semiconductor layer 410, the gate insulating layer 420, the gate 430, the source 440, and the drain 450. By controlling an input voltage of the gate 430, each of the thin-film transistors 400 can control the on and off of a current at both ends of the source 440 and the drain 450.

The present invention is described by taking a top-gate thin-film transistor as an example for each of the thin-film transistors 400. The top-gate thin-film transistor reduces manufacturing processes of the organic light-emitting diode display panel, thereby reducing manufacturing costs. However, each of the thin-film transistors 400 of the present invention is not limited to the top-gate thin-film transistor, and may also be a bottom-gate thin-film transistor or a thin-film transistor having other structures.

Please refer to FIG. 4, which is a flowchart of steps S361-S362/S362' of the manufacturing method of the organic light-emitting diode display panel of the present invention. In an embodiment, step S36 includes the following steps S361-S362/S362' to form the source 440 and the drain 450 shown in FIG. 1.
S361, filling the through-hole 510 with a conductive material.
S362, electrically connecting the source 440 and the conductive material in the first electrode through-hole 513; or
S362', electrically connecting the drain 450 and the conductive material in the first electrode through-hole 513.

As shown in FIG. 12, in step S361, after the through-holes 510 are formed, the through-holes 510 will be filled with the conductive material. When the source 440 and the drain 450 are formed on the through-holes 510, they are electrically connected to the conductive material in the through-holes 510. Therefore, in each of the thin-film transistors 400, the source 440 is electrically connected to the semiconductor layer 410 through the conductive material in the source through-hole 511, and the drain 450 is electrically connected to the semiconductor layer 410 through the drain through-hole 512. The conductive material is electrically connected to the semiconductor layer 410.

In a process of forming each of the thin-film transistors 400, the purpose of the first electrode through-hole 513 is to electrically connect the source 440 or the drain 450 of each of the thin-film transistors 400 to the first electrode 810 shown in FIG. 1 formed in subsequent step S4. Therefore, as shown in FIG. 12, an embodiment of the present invention selects step S362, which means that the source 440 is electrically connected to the conductive material in the first electrode through-hole 513. In another embodiment, in a process of forming each of the thin-film transistors 400, step S362' may also be selected, so as to electrically connect the drain 450 to the conductive material in the first electrode through-hole 513. Since the work performed by the source 440 or the drain 450 in each of the thin-film transistors 400 is only inputting or outputting a current, the present invention does not limit the source 440 or the drain 450 to be electrically connected to the first electrode 810 shown in FIG. 1.

Please refer to FIG. 13, after step S3 of FIG. 2 is completed, a passivation layer 600 and a first encapsulation layer 710 are sequentially formed on a side of the thin-film transistors 400 away from the thin-film transistor substrate 300. The passivation layer 600 covers the source 440 and the drain 450 of each of the thin-film transistors 400, and further covers the interlayer dielectric layer 500. The passivation layer 600 not only has an insulating effect, but also imparts toughness to the organic light-emitting diode display panel when flexed. In addition, a semi-finished product of the organic light-emitting diode display panel formed in steps S1-S3 is attached to a second substrate 120 through the first encapsulation layer 710 to facilitate subsequent manufacturing processes.

Before step S4 in FIG. 2, the manufacturing method of the organic light-emitting diode display panel of the present invention further includes separating the first substrate 110 from the peeling layer 200. Before the manufacturing method of the organic light-emitting diode display panel of the present invention proceeds to step S4, the first substrate 110 in a semi-finished product of the organic light-emitting diode display panel formed in the previous step is removed.

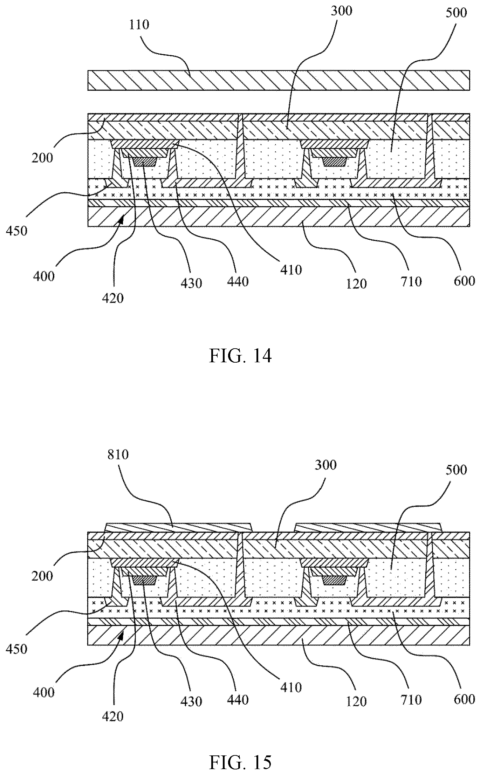

Please refer to FIG. 14, which shows a semi-finished product of the organic light-emitting diode display panel turned upside down. In order to remove the first substrate 110, the present invention flips the semi-finished organic light-emitting diode display panel in this manufacturing process, and uses a laser ablation process to peel the first substrate 110 from the peeling layer 200. By focusing a high-power nanosecond-femtosecond pulsed laser on an interface between the peeling layer 200 and the first substrate 110, when the peeling layer 200 made of gallium nitride is irradiated by the laser, it will generate gas, so that a bonding between the interfaces disappears. When there is no bonding force between the first substrate 110 and the peeling layer 200, the first substrate 110 can be removed from the semi-finished product of the organic light-emitting diode display panel to facilitate subsequent processes.

Please refer to FIG. 15, which shows a semi-finished product of the organic light-emitting diode display panel turned upside down. In step S4 of FIG. 2, the organic light-emitting diodes 800 are formed on the side of the peeling layer 200 away from the thin-film transistor substrate 300 through the photolithography process. Each of the organic light-emitting diodes 800 corresponds to each of the thin-film transistors 400. Each of the organic light-emitting diodes 800 includes the first electrode 810, a light-emitting layer 820, and a second electrode 840. The source 440 or the drain 450 of each of the thin-film transistors 400 are electrically connected to the first electrode 810. Since the subsequent processes are all performed on the side of the peeling layer 200 away from the thin-film transistor substrate 300, when the first electrode 810 is disposed on a flat surface of the peeling layer 200, the light-emitting layer 820 shown in FIG. 1 can achieve the best space utilization efficiency and increase a pixel density of the organic light-emitting diode display panel.

In addition, it should be noted that the semiconductor layer 410 of each of the thin-film transistors 400 is sensitive to light. When light is irradiated on the semiconductor layer 410, a drift current effect is likely to occur and affect a driving effect of each of the thin-film transistors 400. Therefore, the traditional technology usually requires additional light-shielding layers to be provided on an upper side and a lower side of the semiconductor layer 410 of each of the thin-film transistors 400.

However, in the present invention, the gate 430, the source 440, the drain 450, and the first electrode 810 can also provide a light shielding effect for the semiconductor layer 410, which can block light from irradiating the semiconductor layer 410. Meanwhile, since the gate 430, the source 440, and the drain 450 are formed on a side of the semiconductor layer 410, and the first electrode 810 is formed on a side of the semiconductor layer 410 away from the gate 430, the source 440, and the drain 450, the gate 430, the source 440, the drain 450, and the first electrode 810 can achieve the light-shielding effect of the light-shielding layer in the prior art, so the present invention can also simplify a structure of the organic light-emitting diode display panel.

In order to achieve the above-mentioned purpose, in an embodiment of the present invention, a total projected area of the gate 430, the source 440, and the drain 450 on the semiconductor layer 410 is greater than or equal to an area of the semiconductor layer 410. In addition, an area of the first electrode 810 is configured to be greater than or equal to an area of the semiconductor layer 410 of each of the thin-film transistors 400. Also, a material of the first electrode 810 is an opaque conductive material, such as silver (Ag), indium tin oxide/silver/indium tin oxide (ITO/Ag/ITO) composite layer, indium zinc oxide/silver/ indium zinc oxide (IZO/Ag/IZO) composite layer, indium tin oxide/silver palladium copper alloy/indium tin oxide (ITO/APC/ITO) composite layer, or indium zinc oxide/silver palladium copper alloy/indium zinc oxide (IZO/APC/IZO) composite layer.

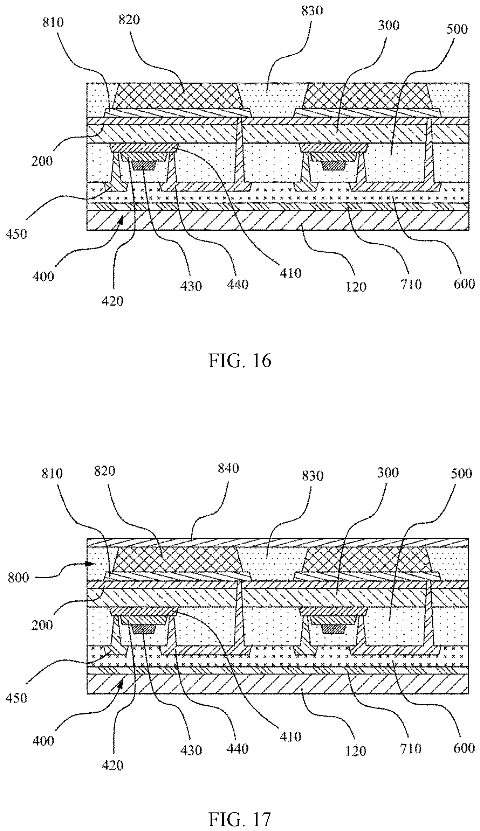

Please refer to FIG. 16, which shows a semi-finished product of the organic light-emitting diode display panel turned upside down. In step S4 of FIG. 2, the present invention forms the light-emitting layer 820 on a side of the first electrode 810 away from the peeling layer 200 through an inkjet printing process. Meanwhile, a pixel spacer 830 is filled between the light-emitting layers 820, so that the light-emitting layer 820 forms pixels of the organic light-emitting diode display panel.

Please refer to FIG. 17, which shows a semi-finished product of the organic light-emitting diode display panel turned upside down. In the present invention, the second electrode 840 is formed on a side of the light-emitting layer 820 away from the first electrode 810. The second electrode 840 covers the light-emitting layer 820 and the pixel spacer 830, and works as a common electrode with the first electrode 810 to drive the light-emitting layer 820 to emit light.

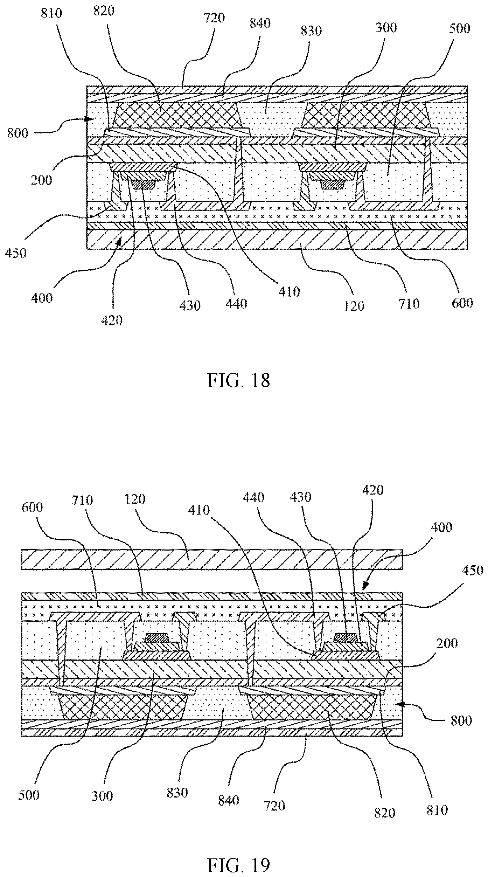

Please refer to FIG. 18, after step S4 of FIG. 2 is completed, the present invention forms a second encapsulation layer 720 on a side of the second electrode 840 away from the light-emitting layer 820. The semi-finished product of the organic light-emitting diode display panel formed in steps S1-S4 is encapsulated by the second encapsulation layer 720 to protect the organic light-emitting diode display panel.

At last, please refer to FIG. 19, the present invention separates the second substrate 120 from the first encapsulation layer 710 through the laser ablation process. In order to remove the second substrate 120, the present invention flips the semi-finished organic light-emitting diode display panel again in this manufacturing process, and focuses the high-power nanosecond-femtosecond pulsed laser on the first encapsulation layer 710 When the first encapsulation layer 710 is irradiated by the laser it will generate gas, so that a bonding between the interfaces disappears. When there is no bonding force between the second substrate 120 and the first encapsulation layer 710, the second substrate 120 can be removed from the semi-finished product of the organic light-emitting diode display panel.

In the manufacturing method of the organic light-emitting diode display panel of the present invention, the traditional leveling layer and the organic light-emitting diodes 800 are not formed on the thin-film transistors 400. On the contrary, the organic light-emitting diodes 800 are formed on the side of the thin-film transistor substrate 300 away from the thin-film transistors 400. Therefore, in the organic light-emitting diode display panel of the present invention, the organic light-emitting diodes 800 are formed on a flat surface and will not be affected by surface fluctuations caused by the gates 430 of the thin-film transistors 400. Since the organic light-emitting diodes 800 can be formed on the flat surface, a space usage of the light-emitting layer 820 can be maximized, thereby increasing the pixel density of the organic light-emitting diode display panel. Meanwhile, the gate 430, the source 440, the drain 450, and the first electrode 810 formed on an upper side and a lower side of each of the thin-film transistors 400 can also function as the light-shielding layer that blocks light for the semiconductor layer 410 in each of the thin-film transistors 400. This can simplify the manufacturing processes of the organic light-emitting diode display panel, increase a display efficiency of the thin-film transistors, and enhance a light-emitting effect of the organic light-emitting diode display panel, so as to enable viewers to obtain a better viewing effect.

The description above are only preferred embodiments of the invention. It should be pointed out that to those of ordinary skill in the art, various improvements and embellishments may be made without departing from the principle of the present invention, and these improvements and embellishments are also deemed to be within the scope of protection of the present invention.

## Claims

1. An organic light-emitting diode display panel, comprising:
a thin-film transistor substrate;
a plurality of thin-film transistors disposed on a side of the thin-film transistor substrate; and
a plurality of organic light-emitting diodes disposed on a side of the thin-film transistor substrate away from the thin-film transistors.

2. The organic light-emitting diode display panel according to claim 1, wherein each of the thin-film transistors comprises a gate, a source, a drain, and a semiconductor layer, and the semiconductor layer is electrically connected to the source and the drain;
each of the organic light-emitting diodes corresponds to each of the thin-film transistors and comprises a first electrode, a light-emitting layer, and a second electrode, and the first electrode is electrically connected to the source or the drain; and
the first electrode is disposed on the side of the thin-film transistor substrate away from the thin-film transistors, the light-emitting layer is disposed on a side of the first electrode away from the thin-film transistor substrate, and the second electrode is disposed on a side of the light-emitting layer away from the first electrode.

3. The organic light-emitting diode display panel according to claim 2, wherein an area of the first electrode is greater than or equal to an area of the semiconductor layer, and the first electrode blocks light from irradiating the semiconductor layer.

4. The organic light-emitting diode display panel according to claim 3, wherein a material of the first electrode comprises an opaque material.

5. The organic light-emitting diode display panel according to claim 2, wherein the source and the drain are disposed on a side of the semiconductor layer away from the thin-film transistor substrate, and the gate is disposed on a side of the source and the drain away from the semiconductor layer.

6. The organic light-emitting diode display panel according to claim 2, wherein the gate is disposed on a side of the semiconductor layer away from the thin-film transistor substrate, and the source and the drain are disposed on a side of the gate away from the semiconductor layer.

7. The organic light-emitting diode display panel according to claim 6, wherein a total projected area of the gate, the source, and the drain on the semiconductor layer is greater than or equal to an area of the semiconductor layer, and the gate, the source, and the drain block light from irradiating the semiconductor layer.

8. The organic light-emitting diode display panel according to claim 2, wherein the thin-film transistor substrate comprises a through-hole, and the first electrode is electrically connected to the thin-film transistor through the through-hole.

9. The organic light-emitting diode display panel according to claim 1, wherein the organic light-emitting diode display panel further comprises a peeling layer disposed between the thin-film transistor substrate and the organic light-emitting diodes.

10. The organic light-emitting diode display panel according to claim 9, wherein a material of the peeling layer comprises gallium nitride.

11. A manufacturing method of an organic light-emitting diode display panel, comprising steps of:
S 1, forming a peeling layer;
S2, forming a thin-film transistor substrate on a side of the peeling layer;
S3, forming a plurality of thin-film transistors on a side of the thin-film transistor substrate away from the peeling layer; and
S4, forming a plurality of organic light-emitting diodes on a side of the peeling layer away from the thin-film transistor substrate.

12. The manufacturing method of the organic light-emitting diode display panel according to claim 11, wherein step S3 comprises steps of:
S31, forming a semiconductor layer on the side of the thin-film transistor substrate away from the peeling layer;
S32, forming a gate insulating layer on a side of the semiconductor layer away from the thin-film transistor substrate;
S33, forming a gate on a side of the gate insulating layer away from the semiconductor layer;
S34, forming an interlayer dielectric layer on the side of the thin-film transistor substrate away from the peeling layer;
S35, defining a through-hole passing through the interlayer dielectric layer, the thin-film transistor substrate, and the peeling layer; and
S36, forming a source and a drain on a side of the interlayer dielectric layer away from the thin-film transistor substrate.

13. The manufacturing method of the organic light-emitting diode display panel according to claim 12, wherein a total projected area of the gate, the source, and the drain on the semiconductor layer is greater than or equal to an area of the semiconductor layer, and the gate, the source, and the drain block light from irradiating the semiconductor layer.

14. The manufacturing method of the organic light-emitting diode display panel according to claim 12, wherein step S36 comprises steps of:
S361, filling the through-hole with a conductive material;
S362, electrically connecting the source and the conductive material in the through-hole; or
S362', electrically connecting the drain and the conductive material in the through-hole.

15. The manufacturing method of the organic light-emitting diode display panel according to claim 11, wherein step S4 comprises a step of forming a first electrode on a side of the thin-film transistor substrate away from the thin-film transistors, forming a light-emitting layer on a side of the first electrode away from the thin-film transistor substrate, and forming a second electrode on a side of the light-emitting layer away from the first electrode.

16. The manufacturing method of the organic light-emitting diode display panel according to claim 15, wherein an area of the first electrode is greater than or equal to an area of the semiconductor layer, and the first electrode blocks light from irradiating the semiconductor layer.

17. The manufacturing method of the organic light-emitting diode display panel according to claim 15, wherein a material of the first electrode comprises an opaque material.

18. The manufacturing method of the organic light-emitting diode display panel according to claim 11, wherein step S1 comprises a step of forming a peeling layer on a side of a first substrate; and
before step S4, the manufacturing method further comprises a step of separating the first substrate from the peeling layer.

19. The manufacturing method of the organic light-emitting diode display panel according to claim 18, wherein the peeling layer is separated from the first substrate by a laser ablation process.

20. The manufacturing method of the organic light-emitting diode display panel according to claim 11, wherein a material of the peeling layer comprises gallium nitride.
